# EUROPEAN PATENT APPLICATION

(11) **EP 4 383 323 A1**
(43) Date of publication of application: **12.06.2024**
(21) Application number: 22874950.3
(22) Date of filing: 28.09.2022
(51) Int. Cl.: H01L 21/768

(54) **POWER SEMICONDUCTOR DEVICE, PREPARATION METHOD THEREFOR, AND ELECTRONIC APPARATUS**

(30) Priority: 30.09.2021 CN 202111164572
(71) Applicant: Huawei Technologies Co., Ltd., Shenzhen, Guangdong 518129 (CN)
(72) Inventor: WU, Ming, Shenzhen, Guangdong 518129 (CN); ZHOU, Jian, Shenzhen, Guangdong 518129 (CN); DING, Yonghuan, Shenzhen, Guangdong 518129 (CN)
(74) Representative: Körber, Martin Hans
(86) International application number: PCT/CN2022/121965
(87) International publication number: WO 2023/051565

(57) **Abstract**

This application provides a power semiconductor device, a method for preparing a power semiconductor device, and an electronic apparatus. The power semiconductor device includes a function layer, a first metal portion, a second metal portion, and an insulation layer. The function layer includes a first area, a second area, and a third area. The third area is located between the first area and the second area. The function layer further includes a first blocking groove provided in the third area. The first metal portion is disposed on the first area. The second metal portion is disposed on the second area. The insulation layer includes a main body and a first blocking portion that are connected. The main body covers the first metal portion, the second metal portion, and the third area. The first blocking groove is filled with the first blocking portion. The function layer further includes at least one passivation layer.

## Description

This application claims priority to Chinese Patent Application No. 202111164572.X, filed with the China National Intellectual Property Administration on September 30, 2021 and entitled "POWER SEMICONDUCTOR DEVICE, METHOD FOR PREPARING POWER SEMICONDUCTOR DEVICE, AND ELECTRONIC APPARATUS", which is incorporated herein by reference in its entirety.

### TECHNICAL FIELD

This application relates to the field of semiconductor technologies, and in particular, to a power semiconductor device, a method for preparing a power semiconductor device, and an electronic apparatus.

### BACKGROUND

A structure of a power semiconductor device (for example, a power supply) includes a passivation layer, a first metal portion, a second metal portion, and an insulation layer. The first metal portion and the second metal portion are spaced apart on the passivation layer. The insulation layer covers the passivation layer, the first metal portion, and the second metal portion. The insulation layer fills between the first metal portion and the second metal portion. However, after the insulation layer and the passivation layer are layered, metal migration (also referred to as electromigration) occurs between the first metal portion and the second metal portion under effect of an electric field between the first metal portion and the second metal portion, a through layer (space or a gap formed due to layering between the insulation layer through which the first metal portion is formed and the passivation layer), and an ion (for example, some ions generated in vapor) concentration. This easily causes a short circuit between the first metal portion and the second metal portion, thereby causing damage to the power semiconductor device. In this case, reliability of the power semiconductor device is affected.

### SUMMARY

Embodiments of this application provide a power semiconductor device, a method for preparing a power semiconductor device, and an electronic apparatus that can improve reliability.

According to a first aspect, this application provides a power semiconductor device, including a function layer, a first metal portion, a second metal portion, and an insulation layer, where the function layer includes a first area, a second area, and a third area, the third area is located between the first area and the second area, the function layer further includes a first blocking groove provided in the third area, the first metal portion covers the first area, the second metal portion is disposed on the second area, the insulation layer includes a main body and a first blocking portion that are connected, the main body is disposed on the first metal portion, the second metal portion, and the third area, the first blocking groove is filled with the first blocking portion, and the function layer further includes at least one passivation layer.

The first blocking portion of the insulation layer is formed in the first blocking groove, and the first blocking portion is not in contact with the first metal portion or the second metal portion. This is equivalent to that a concavely-built structure of the insulation layer is formed in the function layer. The first blocking portion reduces a possibility of layering between the function layer and the insulation layer, thereby effectively reducing a possibility of occurrence of metal migration between the first metal portion and the second metal portion, and reducing a possibility of a short circuit between the first metal portion and the second metal portion, so that reliability of the power semiconductor device is improved. In addition, even if a layering phenomenon occurs between the function layer and the insulation layer, it is difficult for metal in the first metal portion and metal in the second metal portion to grow in a direction opposite to an electric field generated between the first metal portion and the second metal portion, thereby reducing occurrence of through metal migration.

According to a first aspect, in a first possible implementation of the first aspect, the first blocking groove includes a first port and a second port, the first port is disposed on a surface that is of the function layer and that is closest to the first metal portion, the function layer further includes a second blocking groove, the second blocking groove is in communication with the second port, the insulation layer further includes a second blocking portion, the second blocking portion is fastened to an end that is of the first blocking portion and that is away from the main body, and the second blocking groove is filled with the second blocking portion.

The second blocking portion built into the second blocking groove increases a length of an interface between the function layer and the insulation layer, that is, increases a path of metal migration between the first metal portion and the second metal portion, thereby further reducing a possibility of a short circuit between the first metal portion and the second metal portion.

According to the first aspect or the first possible implementation of the first aspect, in a second possible implementation of the first aspect, a diameter of an end that is of the second blocking groove and that is close to the first blocking groove is greater than a diameter of the second port, thereby improving connection stability between the function layer and the insulation layer, further reducing a possibility of layering between the function layer and the insulation layer, and further reducing a possibility of occurrence of metal migration between the first metal portion and the second metal portion.

According to the first aspect or the first to second possible implementations of the first aspect, in a third possible implementation of the first aspect, the function layer further includes a first function layer and a second function layer that are stacked, a material of the first function layer is different from a material of the second function layer, the first metal portion and the second metal portion are disposed on a side that is of the first function layer and that is away from the second function layer, the first blocking groove is located on the first function layer, the second blocking groove is located on the first function layer and/or the second function layer, and at least one of the first function layer and the second function layer is a passivation layer.

According to the first aspect or the first to third possible implementations of the first aspect, in a fourth possible implementation of the first aspect, one of the first function layer and the second function layer is a passivation layer made of Si₃N₄, the other of the first function layer and the second function layer is a passivation layer made of SiO₂, and the second blocking groove is located on the second function layer. For passivation layers made of different materials, stress of adj acent passivation layers can be reduced and a service life of the power semiconductor device can be prolonged.

According to the first aspect or the first to fourth possible implementations of the first aspect, in a fifth possible implementation of the first aspect, the first function layer is a Si layer, the second function layer is a passivation layer, and the second blocking groove is located on the first function layer. The Si layer is configured to protect a passivation layer. Both the first blocking groove and the second blocking groove are provided in the Si layer, so that a structure of the passivation layer is not damaged, and a function of the passivation layer is not affected.

According to a second aspect, this application provides an electronic apparatus, including a circuit board and the power semiconductor device according to the first aspect or the first to fourth possible implementations of the first aspect disposed on the circuit board, where a control circuit is disposed on the circuit board, and the control circuit is configured to control turn-on and turn-off of the power semiconductor device.

According to a third aspect, this application provides a method for preparing a power semiconductor device, including the following steps: providing a prefabricated structure, where a function layer, a first metal portion, and a second metal portion, where the function layer includes a first area, a second area, and a third area, the third area is located between the first area and the second area, the first metal portion is disposed on the first area, the second metal portion is disposed on the second area, and the function layer further includes at least one passivation layer; forming a first blocking groove in the third area of the function layer; and forming an insulation layer, where the insulation layer includes a main body and a first blocking portion that are connected, the main body covers the first metal portion, the second metal portion, and the third area, and the first blocking groove is filled with the first blocking portion.

The first blocking groove is formed on the third area of the function layer, and the first blocking portion that is of a concavely-built structure and that is of the insulation layer is formed in the function layer. The first blocking portion can reduce a possibility of layering between the function layer and the insulation layer, thereby effectively reducing a possibility of occurrence of metal migration between the first metal portion and the second metal portion, and reducing a possibility of a short circuit between the first metal portion and the second metal portion, so that reliability of the power semiconductor device is improved. In addition, even if a layering phenomenon occurs between the function layer and the insulation layer, it is difficult for metal in the first metal portion and metal in the second metal portion to grow in a direction opposite to an electric field generated between the first metal portion and the second metal portion, thereby reducing occurrence of through metal migration.

According to a third aspect, in a first possible implementation of the third aspect, before the forming an insulation layer, the preparation method further includes a step of forming, on the function layer, a second blocking groove in communication with the first blocking groove, where the first blocking groove includes a first port and a second port, the first port is disposed on a surface that is of the function layer and that is closest to the first metal portion, and the second blocking groove is in communication with the second port; and the insulation layer further includes a second blocking portion, and the step of forming an insulation layer further includes: filling the second blocking groove with the second blocking portion.

The second blocking portion built into the second blocking groove increases a length of an interface between the function layer and the insulation layer, that is, increases a path of metal migration between the first metal portion and the second metal portion, thereby further reducing a possibility of a short circuit between the first metal portion and the second metal portion.

According to a third aspect or the first possible implementation of the third aspect, in a second possible implementation of the third aspect, the function layer is a single passivation layer, and the forming a first blocking groove on the function layer includes: placing the prefabricated structure into an etching cavity, and injecting a first gas into the etching cavity by using a process of performing dry etching on a masking dielectric film, to etch the function layer, so that the first blocking groove is formed on the function layer and a protective film is formed on a side wall of the first blocking groove, where the first gas includes a high-carbon-molecule fluorocarbon gas; and the forming a second blocking groove on the function layer includes: injecting a second gas into the etching cavity by using the process of performing dry etching on a masking dielectric film, to etch the function layer, so that the second blocking groove in communication with the second port is formed on the function layer, where the second gas includes a hydrogen fluorocarbon gas.

The function layer is of a single passivation layer structure, thereby simplifying a structure of the power semiconductor device and preparation of the power semiconductor device. In addition, when the first gas is injected into the etching cavity by performing dry etching on a masking dielectric film, to etch the function layer, the first gas includes a high-carbon-molecule fluorocarbon gas, the high-carbon-molecule fluorocarbon gas can generate a relatively large quantity of fluorocarbon-containing thin polymer films, and the equal thin polymer films are deposited on a groove wall of the first blocking groove to form a protective film, to form anisotropic etching on the function layer. When the second gas is injected into the etching cavity by performing dry etching on a masking dielectric film, to etch the function layer, the second gas includes a hydrogen fluorocarbon gas, and the hydrogen fluorocarbon gas performs chemical etching on the function layer, to increase an etching rate and accelerate efficiency of preparing the power semiconductor device.

According to the third aspect or the first to second possible implementations of the third aspect, in a third possible implementation of the third aspect, the function layer includes a first function layer and a second function layer that are stacked, a material of the first function layer is different from a material of the second function layer, the first function layer is a passivation layer made of Si₃N₄, and the second function layer is a passivation layer made of SiO₂; the first metal portion is disposed at the first function layer of the first area, and the second metal portion is disposed at the first function layer of the second area; the forming a first blocking groove on the function layer includes: placing the prefabricated structure into an etching cavity, and injecting a first gas or a second gas into the etching cavity by using a process of performing dry etching on a masking dielectric film, to etch the function layer, so that the first blocking groove is formed on the first function layer, where the first gas includes a high-carbon-molecule fluorocarbon gas, and the second gas includes a hydrogen fluorocarbon gas; and the forming a second blocking groove on the function layer includes: forming the second blocking groove on the second function layer through wet etching.

According to the third aspect or the first to third possible implementations of the third aspect, in a fourth possible implementation of the third aspect, the function layer includes a first function layer and a second function layer that are stacked, a material of the first function layer is different from a material of the second function layer, the first function layer is a Si layer, and the second function layer is a passivation layer; the first metal portion is disposed at the first function layer of the first area, and the second metal portion is disposed at the first function layer of the second area; and the forming a first blocking groove on the function layer includes: placing the prefabricated structure into an etching cavity, and injecting a third gas into the etching cavity by using a process of performing dry etching on a masking dielectric film, to etch the first function layer, so that the first blocking groove is formed on the first function layer, where the third gas includes SF₆; and the forming a second blocking groove on the function layer includes: passing the third gas into the etching cavity by using the process of performing dry etching on a masking dielectric film, to perform isotropic etching on the first function layer, so that the second blocking groove is formed on the second function layer. The Si layer is configured to protect a passivation layer.

According to the third aspect or the first to fourth possible implementations of the third aspect, in a fifth possible implementation of the third aspect, after the forming a first blocking groove on the function layer and before the forming a second blocking groove on the function layer, the preparation method further includes a step of passing a first gas into the etching cavity, and depositing the first gas on a groove wall of the first blocking groove by using a process of performing dry etching on a masking dielectric film, to form a protective film, where the first gas includes a high-carbon-molecule fluorocarbon gas.

The high-carbon-molecule fluorocarbon gas can generate a relatively large quantity of fluorocarbon-containing thin polymer films, and the thin polymer films are deposited on a groove wall of the first blocking groove to form a protective film, to form anisotropic etching on the function layer.

In another implementation, the first blocking groove on the first function layer may be formed in another manner, for example, through wet etching. The second blocking groove on the second function layer may be formed in another manner, for example, through dry etching, for example, by performing dry etching on the second blocking layer by using an HF gas.

### BRIEF DESCRIPTION OF DRAWINGS

FIG. 1 is a schematic diagram of an electronic apparatus according to a first implementation of this application;
FIG. 2 is a schematic diagram of a stacked structure of a power semiconductor device according to a first implementation of this application;
FIG. 3 is a flowchart of a method for preparing a power semiconductor device according to a first implementation of this application;
FIG. 4 is a schematic diagram of a stacked structure of a power semiconductor device according to a second implementation of this application;
FIG. 5 is a flowchart of a method for preparing a power semiconductor device according to a second implementation of this application;
FIG. 6 is a schematic diagram of a structure obtained in step 203 shown in FIG. 5;
FIG. 7 is a schematic diagram of a structure obtained in step 205 shown in FIG. 5;
FIG. 8 is a schematic diagram of a stacked structure of a power semiconductor device according to a third implementation of this application;
FIG. 9 is a flowchart of a method for preparing a power semiconductor device according to a third implementation of this application;
FIG. 10 is a schematic diagram of a structure obtained in step 303 shown in FIG. 9;
FIG. 11 is a schematic diagram of a structure obtained in step 305 shown in FIG. 9;
FIG. 12 is a schematic diagram of a stacked structure of a power semiconductor device according to a fourth implementation of this application;
FIG. 13 is a flowchart of a method for preparing a power semiconductor device according to a fourth implementation of this application;
FIG. 14 is a schematic diagram of a structure obtained in step 403 shown in FIG. 13;
FIG. 15 is a schematic diagram of a structure obtained in step 404 shown in FIG. 14; and
FIG. 16 is a schematic diagram of a structure obtained in step 405 shown in FIG. 14.

### DESCRIPTION OF EMBODIMENTS

A surface-mount technology (surface-mount technology, SMT) is the most popular technology and process in the current electronic assembly industry. Since the surface-mount technology was launched to the market in the early 1970s, the SMT has gradually replaced a conventional wave soldering assembly manner with "manual plug-ins", to become a mainstream of the modern electronic assembly industry. The SMT technology promotes development of electronic parts and components to a chip type, miniaturization, thinning, lightweight, high reliability, and multi-function.

A common power semiconductor device (for example, a power supply) includes a passivation layer, a first metal portion, a second metal portion, and an insulation layer. The first metal portion and the second metal portion are disposed at an interval on the passivation layer. The insulation layer covers the passivation layer, the first metal portion, and the second metal portion. The insulation layer fills between the first metal portion and the second metal portion. However, after a layering phenomenon occurs between the insulation layer and the passivation layer, metal migration occurs between the first metal portion and the second metal portion under effect of an electric field between the first metal portion and the second metal portion, a through layer (space or a gap formed due to layering between the insulation layer through which the first metal portion is formed and the passivation layer), and an ion (for example, some ions generated in vapor) concentration. This easily causes a short circuit between the first metal portion and the second metal portion. For example, when the equal power semiconductor device is soldered on a printed circuit board (printed circuit board, PCB) in an SMT level-2 packaging manner to supply power to the board, if a short circuit occurs between the first metal portion and the second metal portion, a large amount of heat is generated. Consequently, damage to the circuit board is easily caused, and even "the board is burned". In this way, use reliability of the power semiconductor device and a related apparatus thereof is affected.

In another power semiconductor device, a boss is disposed at the passivation layer, but metal of the first metal portion and metal of the second metal portion still bypass the boss at the passivation layer to perform metal migration. Consequently, use reliability of the power semiconductor device is not high.

Based on this, this application provides a power semiconductor device and a related electronic apparatus thereof. The power semiconductor device includes a function layer, a first metal portion, a second metal portion, and an insulation layer. The function layer includes a first area, a second area, and a third area, and the third area is located between the first area and the second area. The function layer further includes a first blocking groove provided in the third area, the first metal portion is disposed on the first area, and the second metal portion is disposed on the second area. The insulation layer includes a main body and a first blocking portion that are connected, the main body covers the first metal portion, the second metal portion, and the third area, and the first blocking groove is filled with the blocking portion. The function layer further includes at least one passivation layer.

The power semiconductor device provided in this application may be applied to various electronic apparatuses that need to use a power semiconductor device. The power semiconductor device is configured to perform power conversion processing, including frequency conversion, voltage transformation, current conversion, power management, and the like. The electronic apparatus may be an electric energy conversion apparatus that needs to use the power semiconductor device. However, the electric energy conversion apparatus may also be carried on an electric energy conversion device to complete various electric power functions of the device. For example, the electronic apparatus in this application may be applied to the field of power systems of electric vehicles. In other words, the electric energy conversion device may be an electric vehicle. The electronic apparatus may be a motor controller, and the power semiconductor device is a power conversion unit assembled in the motor controller. Alternatively, the electronic apparatus may be an on-board charger (on-board charger, OBC), and the power semiconductor device is an energy conversion unit. Alternatively, the electronic apparatus may be a low-voltage control power supply, and the power semiconductor device is a DC-DC conversion unit or the like in the electronic apparatus. In addition, the electronic apparatus in this application is not limited to the field of electric vehicles, and may also be widely applied to the fields of conventional industrial control, communication, smart grids, electric appliances, and the like. For example, the electronic apparatus may be applied to an uninterruptible power supply (uninterruptible power supply, UPS) of a data center, an inverter of a photovoltaic power generation device, a power supply of a server, and a switch-mode power supply of an electric appliance (for example, a refrigerator). It may be understood that, the electronic apparatus is not limited to the electric energy conversion apparatus in this application. In other words, the power semiconductor device is not limited to performing electric energy conversion in this application. The power semiconductor device may also be configured in the electronic apparatus to change a voltage, a frequency, or the like, to implement a circuit control function.

The following further describes this application in detail with reference to specific implementations and accompanying drawings.

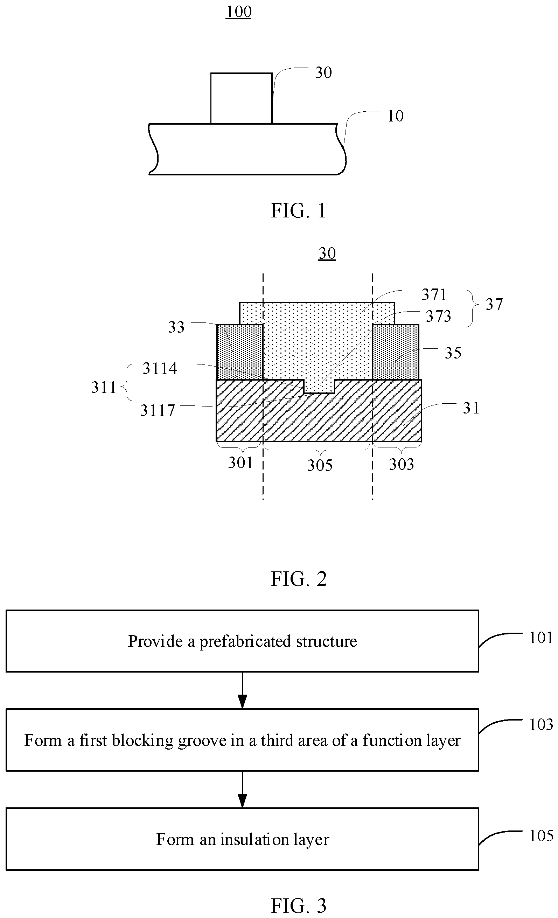

As shown in FIG. 1, a first implementation of this application provides an electronic apparatus 100, including a circuit board 10 and a power semiconductor device 30 located on the circuit board 10. In this implementation, the circuit board 10 may be a network board. For example, a control circuit (not shown in the figure) is disposed on the circuit board 10, and the control circuit is configured to control turn-on and turn-off of the power semiconductor device 30.

As shown in FIG. 2, this application provides a power semiconductor device 30, including a function layer 31, a first metal portion 33, a second metal portion 35, and an insulation layer 37. The function layer 31 includes a first area 301, a second area 303, and a third area 305. The third area 305 is located between the first area 301 and the second area 303. The function layer 31 further includes a first blocking groove 311 provided on the third area 305. The first metal portion 33 covers the first area 301. The second metal portion 35 covers the second area 303. The insulation layer 37 includes a main body 371 and a first blocking portion 373 that are connected. The main body 371 covers the first metal portion 33, the second metal portion 35, and the third area 305. The first blocking groove 311 is filled with the first blocking portion 373. The first blocking portion 373 is configured to block metal migration between the first metal portion 33 and the second metal portion 35, to reduce a possibility of a short circuit between the first metal portion 33 and the second metal portion 35. The power semiconductor device 30 may further include another necessary or unnecessary structure, for example, a substrate. Details are not described herein.

The insulation layer 37 is configured to electrically isolate the first metal portion 33 from the second metal portion 35. In this implementation, the function layer 31 is a passivation layer made of Si₃N₄, and the first metal portion 33 and the second metal portion 35 are redistribution layers (redistribution layer, RDL) made of Cu. The passivation layer is usually configured to protect electronic components under the passivation layer, to prevent the electronic components from being polluted by moisture and impurities that damage physical performance and electrical performance of the components or the like. It may be understood that, in another implementation, the first metal portion 33 and the second metal portion 35 may be made of another material, such as Sn, Au, or Al.

In this implementation, a groove wall of the first blocking groove 311 includes a side wall 3114 and a bottom wall 3117 that are connected. The first blocking portion 373 is attached to the side wall 3114. The first blocking portion 373 is not in contact with the first metal portion 33 or the second metal portion 35.

The first blocking portion 373 of the insulation layer 37 is formed in the first blocking groove 311, and the first blocking portion 373 is not in contact with the first metal portion 33 or the second metal portion 35. This is equivalent to that a concavely-built structure of the insulation layer 37 is formed in the function layer 31. The first blocking portion 373 reduces a possibility of layering between the function layer 31 and the insulation layer 37, thereby effectively reducing a possibility of occurrence of metal migration between the first metal portion 33 and the second metal portion 35, and reducing a possibility of a short circuit between the first metal portion 33 and the second metal portion 35, so that reliability of the power semiconductor device 30 is improved. In addition, even if a layering phenomenon occurs between the function layer 31 and the insulation layer 37, it is difficult for metal in the first metal portion 33 and metal in the second metal portion 35 to grow in a direction opposite to an electric field generated between the first metal portion 33 and the second metal portion 35, thereby reducing occurrence of through metal migration.

As shown in FIG. 3, the first implementation further provides a method for preparing a power semiconductor device 30, including the following steps.

Step 101: Provide a prefabricated structure, where the prefabricated structure includes a function layer 31, a first metal portion 33, and a second metal portion 35, the function layer 31 includes a first area 301, a second area 303, and a third area 305, the third area 305 is located between the first area 301 and the second area 303, the first metal portion 33 is disposed on the first area 301, the second metal portion 35 is disposed on the second area 303, and the function layer 31 further includes at least one passivation layer.

Step 103: Form a first blocking groove 311 on the third area 305 of the function layer 31.

Step 105: Form an insulation layer 37. The insulation layer 37 includes a main body 371 and a first blocking portion 373 that are connected, the main body 371 covers the first metal portion 33, the second metal portion 35, and the third area 305, and the first blocking groove 311 is filled with the first blocking portion 373.

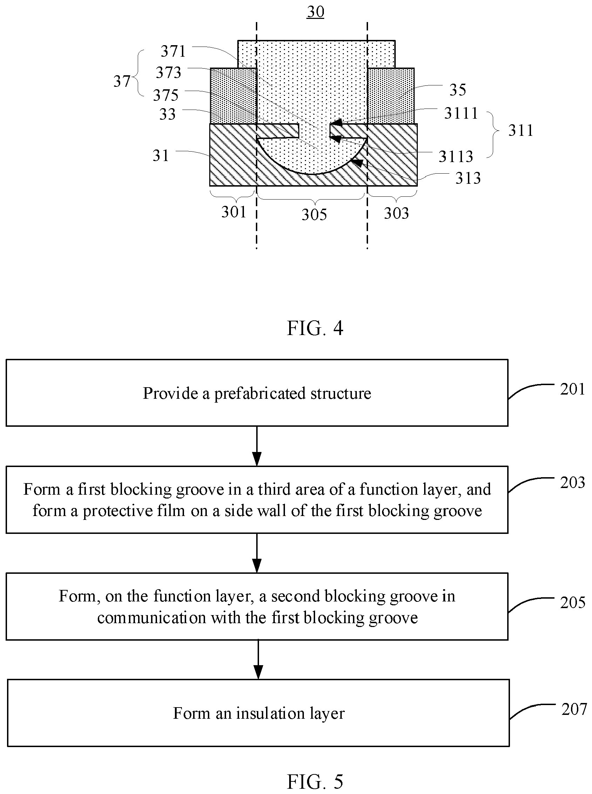

As shown in FIG. 4, a second implementation of this application provides a power semiconductor device 30. A structure of the power semiconductor device 30 provided in the second implementation is approximately similar to that of the power semiconductor device provided in the first implementation. A difference lies in that a function layer 31 further includes a second blocking groove 313 in communication with a first blocking groove 311, and an insulation layer 37 further includes a second blocking portion 375. The second blocking portion 375 is fastened to an end that is of a first blocking portion 373 and that is away from a main body 371. The first blocking groove 311 is filled with the first blocking portion 373. The second blocking groove 313 is filled with the second blocking portion 375.

More specifically, the power semiconductor device 30 includes the function layer 31, a first metal portion 33, a second metal portion 35, and the insulation layer 37. The function layer 31 includes a first area 301, a second area 303, and a third area 305. The third area 305 is located between the first area 301 and the second area 303. The first blocking groove 311 is provided on the third area 305 of the function layer 31. The first metal portion 33 covers the first area 301. The second metal portion 35 covers the second area 303. The main body 371 covers the first metal portion 33, the second metal portion 35, and the third area 305.

The first blocking groove 311 includes a first port 3111 and a second port 3113 that are disposed opposite to each other in a direction parallel to a direction in which the first metal portion 33 and the function layer 31 are stacked. The first port 3111 is disposed on a surface that is of the function layer 31 and that is closest to the first metal portion 33.

The second blocking groove 313 is in communication with the second port 3113. A diameter that is of the second blocking groove 313 and that is close to the second port 3313 of the first blocking groove 311 is greater than a diameter of the second port 3113. The insulation layer 37 further includes the second blocking portion 375, and the second blocking groove 313 is filled with the second blocking portion 375. The second blocking portion 375 built into the second blocking groove 313 increases a length of an interface between the function layer 31 and the insulation layer 37, that is, increases a path of metal migration between the first metal portion 33 and the second metal portion 35, thereby further reducing a possibility of a short circuit between the first metal portion 33 and the second metal portion 35. The diameter that is of the second blocking groove 313 and that is close to the second port 3313 of the first blocking groove 311 is greater than the diameter of the second port 3113, thereby improving connection stability between the function layer 31 and the insulation layer 37, further reducing a possibility of layering between the function layer 31 and the insulation layer 37, and further reducing a possibility of occurrence of metal migration between the first metal portion 33 and the second metal portion 35.

In this implementation, a cross section of the first blocking groove 311 is approximately rectangular, and a part of a cross section of the second blocking groove 313 is approximately circular. It may be understood that a shape of the cross section of the first blocking groove 311 is not limited in this application, and the cross section of the second blocking groove 313 is not limited in this application.

As shown in FIG. 5, the second implementation further provides a method for preparing a power semiconductor device 30, including the following steps.

Step 201: Provide a prefabricated structure. The prefabricated structure includes a function layer 31, a first metal portion 33, and a second metal portion 35. The function layer 31 includes a first area 301, a second area 303, and a third area 305. The third area 305 is located between the first area 301 and the second area 303. The first metal portion 33 covers the first area 301, and the second metal portion 35 covers the second area 303.

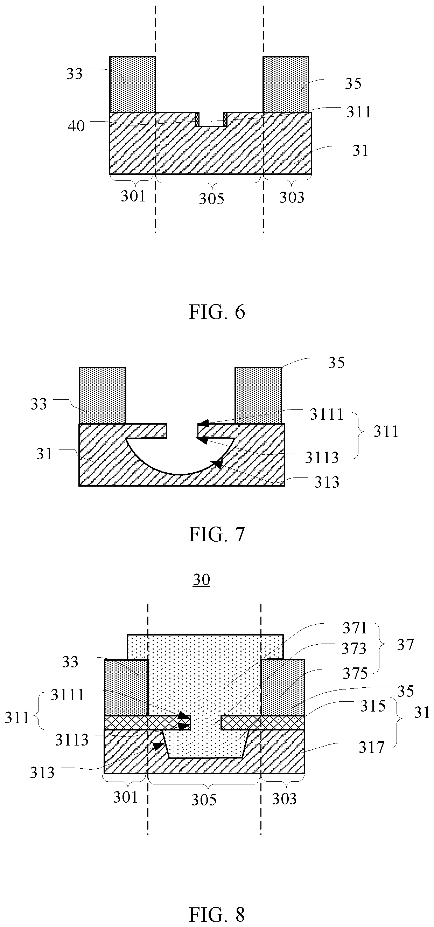

Step 203: As shown in FIG. 6, form a first blocking groove 311 in the third area 305 of the function layer 31, and form a protective film 40 on a side wall of the first blocking groove 311.

As shown in FIG. 4, the first blocking groove 311 includes a first port 3111 and a second port 3113 that are disposed opposite to each other in a direction parallel to a direction in which the first metal portion 33 and the function layer 31 are stacked. The first port 3111 is disposed on a surface that is of the function layer 31 and that is closest to the first metal portion 33.

In this implementation, the function layer 31 is a passivation layer made of Si₃N₄. A prefabricated structure (a sample wafer) with a preset pattern that can be developed through photoetching is placed into an etching cavity. A first gas is injected into the etching cavity by using a process of performing dry etching on a masking dielectric film, to etch the function layer 31, so that the first blocking groove 311 is formed on the function layer 31, and the protective film 40 is formed on the side wall of the first blocking groove 311. The first gas includes a high-carbon-molecule fluorocarbon (such as C₄F₆ or C₄F₈) gas and a dilute gas. The high-carbon-molecule fluorocarbon gas can generate a relatively large quantity of fluorocarbon-containing thin polymer films, and the thin polymer films are deposited on a groove wall of the first blocking groove 311 to form a protective film 40, to form anisotropic etching on the function layer 37. The dilution gas includes He or Ar.

Performing dry etching on a masking dielectric film is an important process technology in manufacturing a semiconductor device. A quantity of reaction gases is injected in a vacuum state, and a plasma is formed under an action of a radio frequency electric field to etch the masking dielectric film made of a semiconductor material, to obtain a required masking shape structure.

Step 205: As shown in FIG. 7, form, on the function layer 31, a second blocking groove 313 in communication with the first blocking groove 311. The second blocking groove 313 is in communication with the second port 3113. A diameter of an end that is of the second blocking groove 313 and that is close to the first blocking groove 311 is greater than a diameter of the first port 3111. In this implementation, a second gas is injected into the etching cavity by performing dry etching on a masking dielectric film, to etch the function layer 31, so that the second blocking groove 313 in communication with the second port 3113 is formed on the function layer 31. The second gas includes a hydrogen fluorocarbon gas. The hydrogen fluorocarbon gas includes one of CHF₃, CH₂F₂, and CH₃F. The second gas is used to perform chemical etching on the function layer 31, to increase an etching rate and efficiency of preparing the power semiconductor device 30. An etched prefabricated structure is cleaned to remove a residual substance, for example, the protective film 40, on the prefabricated structure.

Step 207: As shown in FIG. 4, form an insulation layer 37. The insulation layer 37 includes a main body 371, a first blocking portion 373, and a second blocking portion 375 that are connected. The main body 371 covers the first metal portion 33, the second metal portion 35, and the third area 305. The first blocking groove 311 is filled with the first blocking portion 373. The second blocking groove 313 is filled with the second blocking portion 375.

As shown in FIG. 8, a third implementation of this application provides a power semiconductor device 30. A structure of the power semiconductor device 30 provided in the third implementation is approximately similar to the structure of the power semiconductor device provided in the second implementation. A difference lies in that a function layer 31 further includes a first function layer 315 and a second function layer 317 that are stacked. A material of the first function layer 315 is different from a material of the second function layer 317, a first metal portion 33 and a second metal portion 35 are disposed on a side that is of the first function layer 315 and that is away from the second function layer 317, a first blocking groove 311 is formed through the first function layer 315, and a second blocking groove 313 is located on the second function layer 317.

The first function layer 315 is a passivation layer made of Si₃N₄, and the second function layer 317 is a passivation layer made of SiO₂. For passivation layers made of different materials, stress of adjacent passivation layers can be reduced, and a service life of the power semiconductor device 30 can be prolonged.

In this implementation, a cross section of the first blocking groove 311 is approximately rectangular, and a cross section of the second blocking groove 313 is approximately trapezoid. It may be understood that a shape of the cross section of the first blocking groove 311 is not limited in this application, and the cross section of the second blocking groove 313 is not limited in this application.

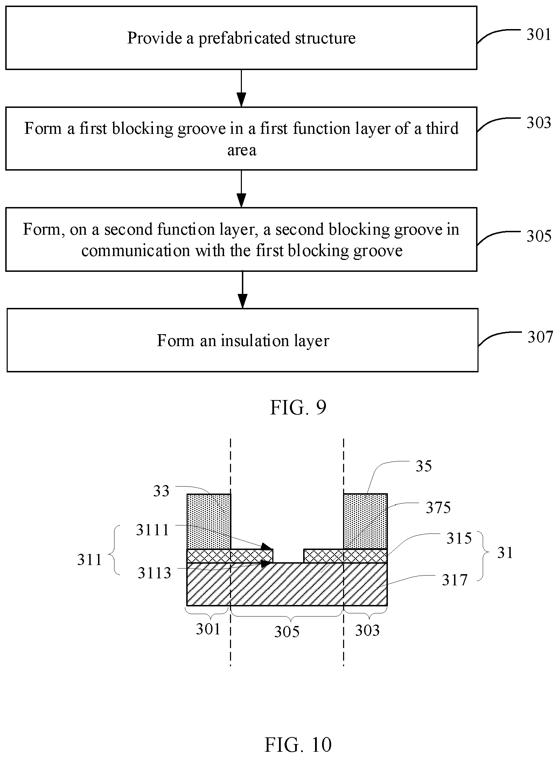

As shown in FIG. 9, the third implementation further provides a method for preparing a power semiconductor device 30, including the following steps.

Step 301: Provide a prefabricated structure. The prefabricated structure includes a function layer 31, a first metal portion 33, and a second metal portion 35. The function layer 31 includes a first area 301, a second area 303, and a third area 305. The third area 305 is located between the first area 301 and the second area 303. The first metal portion 33 covers the first area 301, and the second metal portion 35 covers the second area 303. The function layer 31 further includes a first function layer 315 and a second function layer 317 that are stacked.

The first metal portion 33 is disposed at the first function layer 315 of the first area 301, and the second metal portion 35 is disposed at the first function layer 315 of the second area 303. In this implementation, a material of the first function layer 315 is different from a material of the second function layer 317, and the first metal portion 33 and the second metal portion 35 are disposed on a side that is of the first function layer 315 and that is away from the second function layer 317. The first function layer 315 is a passivation layer made of Si₃N₄, and the second function layer 317 is a passivation layer made of SiO₂.

Step 303: As shown in FIG. 10, form a first blocking groove 311 in the first function layer 315 of the third area 305. The first blocking groove 311 includes a first port 3111 and a second port 3113 that are disposed opposite to each other in a direction parallel to a direction in which the first metal portion 33 and the function layer 31 are stacked. The first port 3111 is disposed on a surface that is of the first function layer 315 and that is closest to the first metal portion 33.

In this implementation, a prefabricated structure (a sample wafer) with a preset pattern that is developed through photoetching is placed into an etching cavity, a first gas or a second gas is injected into the etching cavity by performing dry etching on a masking dielectric film, to etch the function layer 31, so that the first blocking groove 311 is formed on the first function layer 315. The first gas includes a high-carbon-molecule fluorocarbon (such as C₄F₆ or C₄F₈) gas and a dilute gas. The second gas includes a hydrogen fluorocarbon gas, and the hydrogen fluorocarbon gas includes one of CHF₃, CH₂F₂, and CH₃F.

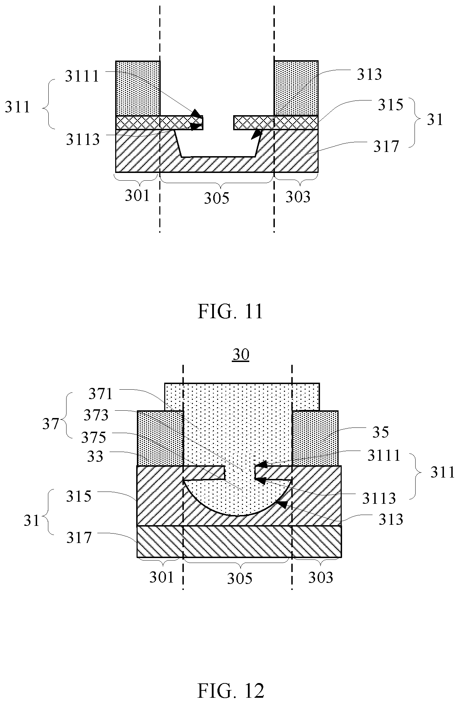

Step 305: As shown in FIG. 11, form, on the second function layer 317, a second blocking groove 313 in communication with the first blocking groove 311. A diameter of an end that is of the second blocking groove 313 and that is close to the first blocking groove 311 is greater than a diameter of the second port 3113. In this implementation, the second blocking groove 313 in communication with the first blocking groove 311 is formed on the second function layer 317 through wet etching, and a corrosion solution for wet etching may be a KOH solution. After the wet etching performed on the second function layer 317 is completed, the prefabricated structure is cleaned by sequentially using deionized water, ethyl alcohol, acetone, ether, and the like. After the cleaning is completed, the prefabricated structure is spin-dried. In another implementation, the corrosion solution may be another solution, and the corrosion solution includes 49%HF and 12%NH₄F.

Step 307: As shown in FIG. 8, form an insulation layer 37. The insulation layer 37 covers the first metal portion 33, the second metal portion 35, and the third area 305, to form the power semiconductor device 30. The insulation layer 37 includes a main body 371, a first blocking portion 373, and a second blocking portion 375 that are connected. The main body 371 covers the first metal portion 33, the second metal portion 35, and the third area 305. The first blocking groove 311 is filled with the first blocking portion 373, and the second blocking groove 313 is filled with the second blocking portion 375.

It may be understood that, a material of the passivation layer is not limited in this application. In another implementation, for example, the first function layer 315 may be a passivation layer made of SiO₂, and the second function layer 317 may be a passivation layer made of Si₃N₄.

As shown in FIG. 12, a fourth implementation of this application provides a power semiconductor device 30. A structure of the power semiconductor device 30 provided in the fourth implementation is approximately similar to the structure of the power semiconductor device provided in the second implementation. A difference lies in that a function layer 31 further includes a first function layer 315 and a second function layer 317 that are stacked. A material of the first function layer 315 is different from a material of the second function layer 317, a first metal portion 33 and a second metal portion 35 are disposed on a side that is of the first function layer 315 and that is away from the second function layer 317, the first blocking groove 311 is located on the first function layer 315, and a second blocking groove 313 is located on the first function layer 315. The first function layer 315 is a Si layer, and the second function layer 317 is a passivation layer made of Si₃N₄. The Si layer is configured to protect a passivation layer. Both the first blocking groove 311 and the second blocking groove 313 are provided on the Si layer, so that a structure of the passivation layer is not damaged, and a function of the passivation layer is not affected.

In this implementation, a cross section of the first blocking groove 311 is approximately rectangular, and a cross section of the second blocking groove 313 is approximately trapezoid. It may be understood that a shape of the cross section of the first blocking groove 311 is not limited in this application, and the cross section of the second blocking groove 313 is not limited in this application.

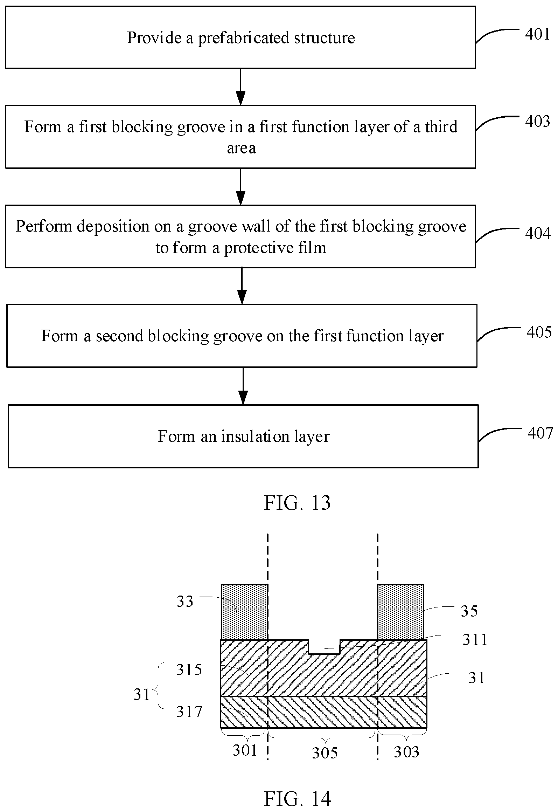

As shown in FIG. 13, the fourth implementation further provides a method for preparing a power semiconductor device 30, including the following steps.

Step 401: Provide a prefabricated structure, where the prefabricated structure includes a function layer 31, a first metal portion 33, and a second metal portion 35, the function layer 31 includes a first area 301, a second area 303, and a third area 305, the third area 305 is located between the first area 301 and the second area 303, the first metal portion 33 covers the first area 301, and the second metal portion 35 covers the second area 303.

The function layer 31 further includes a first function layer 315 and a second function layer 317 that are stacked. A material of the first function layer 315 is different from a material of the second function layer 317. The first metal portion 33 and the second metal portion 35 are disposed on a side that is of the first function layer 315 and that is away from the second function layer 317.

Step 403: As shown in FIG. 14, form a first blocking groove 311 in the first function layer 315 of the third area 305. The first blocking groove 311 includes a first port 3111 and a second port 3113 that are disposed opposite to each other in a direction parallel to a direction in which the first metal portion 33 and the function layer 31 are stacked. The first port 3111 is disposed on a surface that is of the function layer 31 and that is closest to the first metal portion 33.

In this implementation, the prefabricated structure (a sample wafer) with a preset pattern that is developed through photoetching is placed into an etching cavity, a third gas is passed into the etching cavity, and the first function layer 315 is etched by using a process of performing dry etching on a masking dielectric film, so that the first blocking groove 311 is formed on the first function layer 315. The third gas includes SF₆.

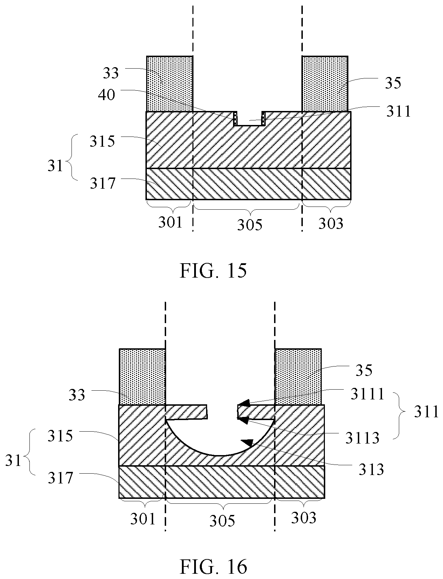

Step 404: As shown in FIG. 15, perform deposition on a groove wall of the first blocking groove 311 to form a protective film 40. The protective film 40 is configured to protect the groove wall of the first blocking groove 311. In this implementation, a first gas is injected into the etching cavity, and is deposited on the groove wall of the first blocking groove 311 by using the process of performing dry etching on a masking dielectric film, to form the protective film 40. The first gas includes C₄F₈.

Step 405: As shown in FIG. 16, form a second blocking groove 313 on the first function layer 315. The second blocking groove 313 is in communication with the second port 3113. A diameter that is of the second blocking groove 313 and that is close to the second port 3113 of the first blocking groove 311 is greater than a diameter of the first port 3111. In this implementation, the third gas is passed into the etching cavity, and isotropic etching is performed on the first function layer 315 by using the process of performing dry etching on a masking dielectric film, to form the second blocking groove 313.

Step 407: As shown in FIG. 12, form an insulation layer 37. The insulation layer 37 covers the first metal portion 33, the second metal portion 35, and the third area 305, to form the power semiconductor device 30. The insulation layer 37 includes a main body 371, a first blocking portion 373, and a second blocking portion 375 that are connected. The main body 371 covers the first metal portion 33, the second metal portion 35, and the third area 305. The first blocking groove 311 is filled with the first blocking portion 373, and the second blocking groove 313 is filled with the second blocking portion 375.

It may be understood that, in another implementation, step 404 may be omitted.

It should be understood that expressions such as "include" and "may include" that may be used in this application indicate existence of the disclosed function, operation, or constituent element, and do not limit one or more additional functions, operations, and constituent elements. In this application, terms such as "include" and/or "have" may be explained as representing a particular feature, quantity, operation, composition element, component, or a combination thereof, but cannot be explained as excluding existence or addition possibility of one or more other features, quantities, operations, composition elements, components, or combinations thereof.

In addition, in this application, the expression "and/or" includes any and all combinations of words listed in association. For example, the expression "A and/or B" may include A, may include B, or may include both A and B.

In this application, expressions including ordinal numbers such as "first" and "second" may modify elements. However, such elements are not limited by the expressions. For example, the expressions do not limit the order and/or importance of the elements. The expression is used only to distinguish one element from another. For example, first user equipment and second user equipment indicate different user equipment, although both the first user equipment and the second user equipment are user equipment. Similarly, without departing from the scope of this application, a first element may be referred to as a second element, and similarly, a second element may also be referred to as a first element.

When a component is referred to as "connecting" or "accessing" another component, it should be understood that the component is not only directly connected to or connected to the another component, but also another component may exist between the component and the another component. In addition, when a component is referred to as a "direct connection" or "direct access" to another component, it should be understood that there is no component between them.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A power semiconductor device, comprising a function layer, a first metal portion, a second metal portion, and an insulation layer, wherein the function layer comprises a first area, a second area, and a third area, the third area is located between the first area and the second area, the function layer further comprises a first blocking groove provided in the third area, the first metal portion is disposed on the first area, the second metal portion is disposed on the second area, the insulation layer comprises a main body and a first blocking portion that are connected, the main body covers the first metal portion, the second metal portion, and the third area, the first blocking groove is filled with the first blocking portion, and the function layer further comprises at least one passivation layer.

2. The power semiconductor device according to claim 1, wherein the first blocking groove comprises a first port and a second port, the first port is disposed on a surface that is of the function layer and that is closest to the first metal portion, the function layer further comprises a second blocking groove, the second blocking groove is in communication with the second port, the insulation layer further comprises a second blocking portion, the second blocking portion is fastened to an end that is of the first blocking portion and that is away from the main body, and the second blocking groove is filled with the second blocking portion.

3. The power semiconductor device according to claim 2, wherein a diameter of an end that is of the second blocking groove and that is close to the first blocking groove is greater than a diameter of the second port.

4. The power semiconductor device according to claim 2 or 3, wherein the function layer further comprises a first function layer and a second function layer that are stacked, a material of the first function layer is different from a material of the second function layer, the first metal portion and the second metal portion are disposed on a side that is of the first function layer and that is away from the second function layer, the first blocking groove is located on the first function layer, the second blocking groove is located on the first function layer and/or the second function layer, and at least one of the first function layer and the second function layer is a passivation layer.

5. The power semiconductor device according to claim 4, wherein one of the first function layer and the second function layer is a passivation layer made of Si₃N₄, the other of the first function layer and the second function layer is a passivation layer made of SiO₂, and the second blocking groove is located on the second function layer.

6. The power semiconductor device according to claim 4, wherein the first function layer is a Si layer, the second function layer is a passivation layer, and the second blocking groove is located on the first function layer.

7. An electronic apparatus, comprising a circuit board and the power semiconductor device according to any one of claims 1 to 6 disposed on the circuit board, wherein a control circuit is disposed on the circuit board, and the control circuit is configured to control turn-on and turn-off of the power semiconductor device.

8. A method for preparing a power semiconductor device, comprising the following steps:
providing a prefabricated structure, wherein the function layer, a first metal portion, and a second metal portion, wherein the function layer comprises a first area, a second area, and a third area, the third area is located between the first area and the second area, the first metal portion is disposed on the first area, the second metal portion is disposed on the second area, and the function layer further comprises at least one passivation layer;
forming a first blocking groove in the third area of the function layer; and
forming an insulation layer, wherein the insulation layer comprises a main body and a first blocking portion that are connected, the main body covers the first metal portion, the second metal portion, and the third area, and the first blocking groove is filled with the first blocking portion.

9. The preparation method according to claim 8, wherein before the forming an insulation layer, the preparation method further comprises a step of forming, on the function layer, a second blocking groove in communication with the first blocking groove, wherein the first blocking groove comprises a first port and a second port, the first port is disposed on a surface that is of the function layer and that is closest to the first metal portion, and the second blocking groove is in communication with the second port; and
the insulation layer further comprises a second blocking portion, and the forming an insulation layer further comprises: filling the second blocking groove with the second blocking portion.

10. The preparation method according to claim 9, wherein the function layer is a single passivation layer, and the forming a first blocking groove on the function layer comprises: placing the prefabricated structure into an etching cavity, and injecting a first gas into the etching cavity by using a process of performing dry etching on a masking dielectric film, to etch the function layer, so that the first blocking groove is formed on the function layer and a protective film is formed on a side wall of the first blocking groove, wherein the first gas comprises a high-carbon-molecule fluorocarbon gas; and
the forming a second blocking groove on the function layer comprises: injecting a second gas into the etching cavity by using the process of performing dry etching on a masking dielectric film, to etch the function layer, so that the second blocking groove in communication with the second port is formed on the function layer, wherein the second gas comprises a hydrogen fluorocarbon gas.

11. The preparation method according to claim 9, wherein the function layer comprises a first function layer and a second function layer that are stacked, a material of the first function layer is different from a material of the second function layer, the first function layer is a passivation layer made of Si₃N₄, and the second function layer is a passivation layer made of SiO₂;
the first metal portion is disposed at the first function layer of the first area, and the second metal portion is disposed at the first function layer of the second area;
the forming a first blocking groove on the function layer comprises: placing the prefabricated structure into an etching cavity, and injecting a first gas or a second gas into the etching cavity by using a process of performing dry etching on a masking dielectric film, to etch the function layer, so that the first blocking groove is formed on the first function layer, wherein the first gas comprises a high-carbon-molecule fluorocarbon gas, and the second gas comprises a hydrogen fluorocarbon gas; and
the forming a second blocking groove on the function layer comprises: forming the second blocking groove on the second function layer through wet etching.

12. The preparation method according to claim 9, wherein the function layer comprises a first function layer and a second function layer that are stacked, a material of the first function layer is different from a material of the second function layer, the first function layer is a Si layer, and the second function layer is a passivation layer;
the first metal portion is disposed at the first function layer of the first area, and the second metal portion is disposed at the first function layer of the second area;
the forming a first blocking groove on the function layer comprises: placing the prefabricated structure into an etching cavity, and injecting a third gas into the etching cavity by using a process of performing dry etching on a masking dielectric film, to etch the first function layer, so that the first blocking groove is formed on the first function layer, wherein the third gas comprises SF₆; and
the forming a second blocking groove on the function layer comprises: passing the third gas into the etching cavity by using the process of performing dry etching on a masking dielectric film, to perform isotropic etching on the first function layer, so that the second blocking groove is formed on the second function layer.

13. The preparation method according to claim 12, wherein after the forming a first blocking groove on the function layer and before the forming a second blocking groove on the function layer, the preparation method further comprises a step of passing a first gas into the etching cavity by using the process of performing dry etching on a masking dielectric film, and depositing the first gas on a groove wall of the first blocking groove to form a protective film, wherein the first gas comprises a high-carbon-molecule fluorocarbon gas.
